# DEMANDE DE BREVET EUROPEEN

(11) **EP 4 575 774 A1**
(43) Date de publication de la demande: **25.06.2025**
(21) Numéro de dépôt: 24218905.8
(22) Date de dépôt: 11.12.2024
(51) Int. Cl.: G06F 9/4401, G06F 13/38, H03M 9/00

(54) **COMMUNICATION PAR SÉRIALISEUR/DÉSÉRIALISEUR**

(30) Priorité: 20.12.2023 FR 2314545
(71) Demandeur: STMicroelectronics International N.V., 1228 Plan-les-Ouates, Geneva (CH)
(72) Inventeur: COFLER, Andrew, 38500 VOIRON (FR); JACQUET, David, 38410 VAULNAVEYS LE HAUT (FR); POZZONI, Massimo, 27100 PAVIA (IT)
(74) Mandataire: Cabinet Beaumont

(57) **Abrégé**

La présente description concerne un dispositif électronique (102) adapté à mettre en oeuvre une communication par sérialiseur/désérialiseur comprenant une première mémoire (1022) adaptée à stocker un premier logiciel (10221) adapté à initialiser ladite communication, ledit premier logiciel (10221) étant différent d'un deuxième logiciel (1031) adapté mettre en oeuvre ladite communication.

## Description

### Domaine technique

La présente description concerne de façon générale les circuits et dispositifs électroniques, et les communications entre plusieurs circuits ou dispositifs électroniques. La présente description se rapporte plus particulièrement, au communication utilisant un module sérialiseur/désérialiseur.

### Technique antérieure

Les composants sérialiseur/désérialiseur (SerDes, Serializer/Deserializer), ou modules sérialiseur/désérialiseur, sont des composants permettant, à des dispositifs électroniques, de mettre en oeuvre des communications transférant un haut débit de données. Ces composants sérialiseur/désérialiseur sont généralement intégrés aux dispositifs électroniques mettant en oeuvre la communication.

Il serait souhaitable de pouvoir améliorer, au moins en partie, certains aspects des communication utilisant des composants sérialiseur/désérialiseur.

### Résumé de l'invention

Il existe un besoin pour des communications par sérialiseur/désérialiseur plus efficace.

Il existe un besoin pour des dispositifs électroniques mettant en oeuvre des communications utilisant des composants sérialiseur/désérialiseur plus efficaces.

Il existe un besoin pour des dispositifs électroniques mettant en oeuvre des communications utilisant des composants plus compacts.

Un mode de réalisation pallie tout ou partie des inconvénients des dispositifs électroniques mettant en oeuvre des communications utilisant des composants sérialiseur/désérialiseur.

Un mode de réalisation pallie tout ou partie des inconvénients des procédés connus d'initialisation de communication par sérialiseur/désérialiseur.

Un mode de réalisation pallie tout ou partie des inconvénients des procédés connus de communication par sérialiseur/désérialiseur.

Un mode de réalisation prévoit un dispositif électronique stockant uniquement un logiciel adapté à initialiser une communication par sérialiseur/désérialiseur.

Un mode de réalisation prévoit un procédé d'initialisation une communication par sérialiseur/désérialiseur mis en oeuvre par le dispositif décrit précédemment.

Un mode de réalisation prévoit un dispositif électronique adapté à mettre en oeuvre une communication par sérialiseur/désérialiseur comprenant une première mémoire adaptée à stocker un premier logiciel adapté à initialiser ladite communication, ledit premier logiciel étant différent d'un deuxième logiciel adapté mettre en oeuvre ladite communication.

Un autre mode de réalisation prévoit un procédé d'initialisation d'une communication par sérialiseur/désérialiseur par un dispositif électronique comprenant une première mémoire adaptée à stocker un premier logiciel adapté à initialiser ladite communication, ledit premier logiciel étant différent d'un deuxième logiciel adapté mettre en oeuvre ladite communication.

Selon un mode de réalisation, ladite première mémoire est une mémoire morte programmable.

Selon un mode de réalisation, le premier logiciel est une version abrégée dudit deuxième logiciel.

Selon un mode de réalisation, une fois que le premier logiciel a été utilisé, ledit dispositif est adapté à recevoir ledit deuxième logiciel.

Selon un mode de réalisation, ledit deuxième logiciel est envoyé par un premier circuit de commande externe audit dispositif.

Selon un mode de réalisation, ledit deuxième logiciel est stocké dans une deuxième mémoire dudit dispositif.

Selon un mode de réalisation, la deuxième mémoire est une mémoire vive statique d'un module sérialiseur/désérialiseur dudit dispositif.

Selon un mode de réalisation, ledit premier logiciel est adapté à initialiser ladite communication ayant un premier débit de donnée inférieur à un deuxième débit de données de ladite communication quand elle est mise en oeuvre par ledit deuxième logiciel.

Selon un mode de réalisation, ledit premier logiciel est adapté à initialiser ladite communication ayant premières fonctionnalités différentes de deuxièmes fonctionnalités de ladite communication quand elle est mise en oeuvre par ledit deuxième logiciel.

Un autre mode de réalisation prévoit un procédé de communication d'une communication par sérialiseur/désérialiseur comprenant le procédé décrit précédemment.

Un autre mode de réalisation prévoit un système électronique comprenant au moins un dispositif décrit précédemment.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un système électronique au sein duquel est mise en oeuvre, selon un mode de réalisation, une communication par sérialiseur/désérialiseur ; et
la figure 2 représente un mode de mise en oeuvre d'une procédé de démarrage d'une communication par sérialiseur/désérialiseur au sein du système de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas" , "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Les modes de réalisation décrits ci-après concernent des dispositifs adaptés à mettre en oeuvre une communication par sérialiseur/désérialiseur. Une telle communication est une communication entre des dispositifs électroniques utilisant des composants sérialiseur/désérialiseur (SerDes, Serializer/Deserializer), intégrés aux dispositifs électroniques, pour transmettre des données. De tels composants permettent de transmettre des données, normalement diffusées sur plusieurs canaux de communication, sur un seul canal de communication. Autrement dit, un tel composant permet de mettre en série des données reçues en parallèle sur plusieurs entrées. Pour mettre en oeuvre une telle communication, les dispositifs électroniques ont généralement besoin de pouvoir mettre en oeuvre un logiciel associé à la communication par sérialiseur/désérialiseur. Ce logiciel est généralement un programme très bas niveau, aussi appelé microcode ou microprogramme (firmware).

Les modes de réalisation décrits ci-après pallient un problème de stockage du logiciel associé à la communication par sérialiseur/désérialiseur dans un dispositif électronique la mettant en oeuvre. En effet, un tel logiciel est généralement stocké dans une mémoire non volatile externe au composant sérialiseur/désérialiseur dudit dispositif. Pour des raisons d'encombrement et de coûts financiers, certains dispositifs ne peuvent comprendre de mémoire non volatile permettant de stocker de logiciel. Pour cela, les modes de réalisation décrits ci-après comprennent une mémoire morte programmable, c'est-à-dire une mémoire qui ne peut être programmée qu'une seule fois, adaptée à stocker une version abrégée du logiciel permettant seulement d'initialiser une communication par sérialiseur/désérialiseur limitée. Une fois la communication initialisée, le composant sérialiseur/désérialiseur du dispositif est adapté à recevoir et à stocker, dans une de ses mémoires internes ledit logiciel complet.

De plus, ces modes de réalisation peuvent être appliqués à tout système électronique utilisant un plusieurs composants sérialiseur/désérialiseur, comme, par exemple, des systèmes de communication, comme des antennes, par exemple des antennes actives, des systèmes de stockage de données, comme des centres de données (Data Center), etc. Ces modes de réalisation sont tout particulièrement adaptés à des systèmes électroniques comprenant un grand nombre de dispositifs électroniques adaptés à mettre en oeuvre entre eux une communication par sérialiseur/désérialiseur.

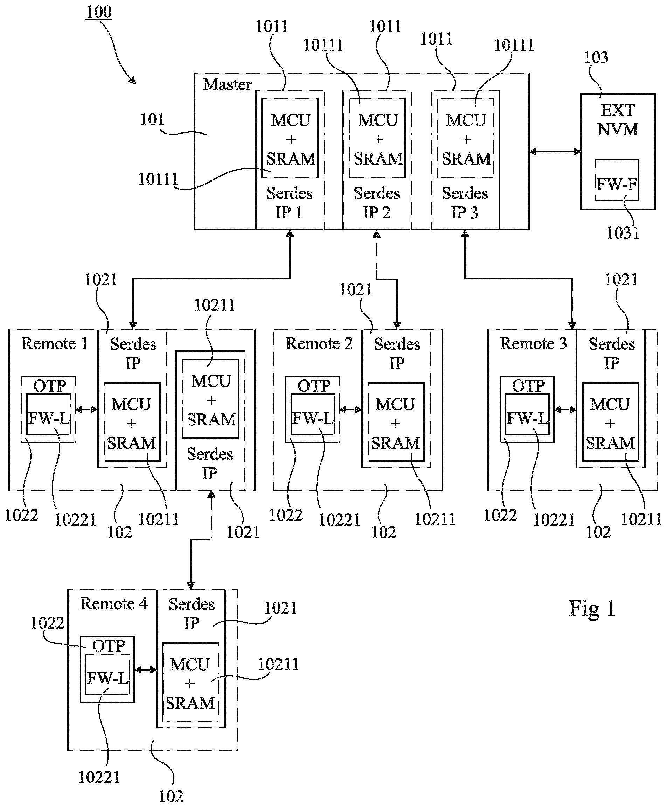

La figure 1 représente, schématiquement et sous forme de bloc, un mode de réalisation d'un système électronique 100 selon un mode de réalisation.

Le système 100 comprend plusieurs dispositifs électroniques, par exemple au moins deux dispositifs électroniques, adaptés à mettre en oeuvre une communication par sérialiseur/désérialiseur. Dans l'exemple illustré en figure 1, le système 100 comprend cinq dispositifs électroniques parmi lesquels un dispositif électronique 101 (Master) maître, ou commandant (commander), et quatre dispositifs électroniques 102 (Remote 1, Remote 2, Remote 3, Remote 4) distant, esclave, ou répondeur (responder).

Chaque dispositif électronique 101, 102 du système 100 comprend au moins un composant sérialiseur/désérialiseur 1011, respectivement 1021, ou module sérialiseur/désérialiseur lui permettant de mettre en oeuvre une communication sérialiseur/désérialiseur avec un autre dispositif du système 100. Plus particulièrement, chaque dispositif électronique 101, 102 comprend un module sérialiseur/désérialiseur pour chaque autre dispositif électronique avec qui il est adapté à mettre en oeuvre une communication sérialiseur/désérialiseur. Autrement dit, si un dispositif électronique est adapté à communiquer avec deux autres dispositifs électroniques, il comprend alors deux modules sérialiseur/désérialiseur. Dans l'exemple illustré en Figure 1, le dispositif électronique 101 est adapté à mettre en oeuvre une communication par sérialiseur/désérialiseur avec trois des dispositifs 102 (Remote 1, Remote 2, Remote 3), et un dispositif 102 (Remote 4) n'est adapté à mettre en oeuvre une communication qu'avec un des autres dispositifs 102 (Remote 1). Ainsi, le dispositif 101 comprend trois modules sérialiseur/désérialiseur, et chaque dispositif 102 comprend un module sérialiseur/désérialiseur, sauf un dispositif 102 (Remote 1) qui comprend deux modules sérialiseur/désérialiseur.

Plus particulièrement, le dispositif 101 comprend :
- un module sérialiseur/désérialiseur 1011 portant la référence "Serdes IP 1" adapté à communiquer avec le dispositif 102 portant la référence "Remote 1" ;
- un module sérialiseur/désérialiseur 1011 portant la référence "Serdes IP 2" adapté à communiquer avec le dispositif 102 portant la référence "Remote 2" ; et
- un module sérialiseur/désérialiseur 1011 portant la référence "Serdes IP 3" adapté à communiquer avec le dispositif 102 portant la référence "Remote 3".

Selon un mode de réalisation, chaque composant 1011, 1021 comprend un circuit de commande accompagné d'une mémoire 10111 (MCU+SRAM), respectivement 10211 (MCU+SRAM). Selon un exemple, le circuit de commande est un processeur, un microprocesseur, un contrôleur, ou un microcontrôleur. Selon un mode de réalisation préféré, le circuit de commande principal 101 est un microcontrôleur. Selon un mode de réalisation, la mémoire est une mémoire vive, comme, de préférence, une mémoire vive statique (SRAM, Static Random Access Memory).

Selon un exemple, le dispositif électronique est un dispositif électronique complexe, comme un processeur ou un microprocesseur.

Selon un mode de réalisation, chaque dispositif 102 comprend, en plus de son composant 1021, au moins une mémoire morte programmable 1022 (OTP) de petite capacité. Selon un exemple, la mémoire 1022 a une capacité de quelques kilobytes, par exemple inférieure à 5 kBytes. Selon un mode de réalisation, la mémoire morte programmable 1022 est une mémoire programmable une seule fois (OTP, One-Time Programmable).

De plus, le système 100 comprend, en outre, au moins une mémoire non volatile 103 (EXT NVM) externe aux dispositifs 101 et 102. Selon un exemple, la mémoire non volatile 103 peut être accessible au dispositif 101, mais n'est pas accessible aux dispositifs 102. Selon un exemple, la capacité de stockage de la mémoire 103 est supérieure à la capacité de stockage des mémoires mortes programmables 1022 des dispositifs 102.

Pour mettre en oeuvre une communication par sérialiseur/désérialiseur, chaque dispositif 101, 102 doit mettre en oeuvre un logiciel adapté à mettre en oeuvre une telle communication. Plus particulièrement, chaque circuit de commande 10111, respectivement 10211, doit mettre en oeuvre un logiciel adapté à mettre en oeuvre une telle communication. Pour cela, un tel logiciel doit être stocké dans la mémoire accompagnant le chaque circuit de commande 10111, respectivement 10211.

Comme dit précédemment, ce logiciel est généralement un programme très bas niveau, aussi appelé microcode ou microprogramme, logiciel pilote ou logiciel de pilotage (firmware). Un programme très bas niveau est un programme informatique permettant directement de commander les composants électroniques matériels (hardware), sans autre intermédiaire logiciel. Selon un mode de réalisation, ce logiciel est un microcode adapté à envoyer directement des commandes à un ou plusieurs circuits et composants électroniques chargés de mettre en oeuvre une communication par sérialiseur/désérialiseur.

Selon un mode de réalisation, chaque dispositif 102 est adapté à stocker dans sa mémoire 1022, non pas le logiciel permettant de mettre en oeuvre une communication par sérialiseur/désérialiseur, mais un logiciel 10221 (FW_L) adapté à, au moins, initialiser une communication par sérialiseur/désérialiseur limitée, c'est-à-dire déclencher ou activer des circuits chargés de mettre en oeuvre une communication par sérialiseur/désérialiseur limitée. Un logiciel 1031 (FW_F) permettant de mettre en oeuvre une communication par sérialiseur/désérialiseur est, quant à lui, stocké dans la mémoire non volatile externe 103 du système 100. Selon un exemple, le logiciel 1031 est adapté à déclencher ou activer des circuits chargés de mettre en oeuvre une communication par sérialiseur/désérialiseur. Le logiciel 1031 n'est fourni au dispositif 102 que lorsqu'une communication est initialisée. Lorsque le logiciel 1031 est fourni au dispositif 102, il est stocké dans la mémoire associée à son circuit de commande 10211 de son module 1021.

Selon un mode de réalisation, le logiciel 10221 est différent du logiciel 1031 en ce qu'il comprend moins de fonctionnalités. Selon un mode de réalisation, le logiciel 10221 est une version abrégée, ou simplifiée, du logiciel 1031. Ainsi, le code du logiciel 10221 est plus petit que le code du logiciel 1031. Le code du logiciel 10221 peut donc être stocké dans la mémoire 10211 alors que le code du logiciel est trop volumineux pour être stocké par cette mémoire. Un avantage est donc ici de pouvoir s'abstenir de l'installation d'une mémoire non volatile externe au module 1021, et donc de rendre le système 100 plus compact.

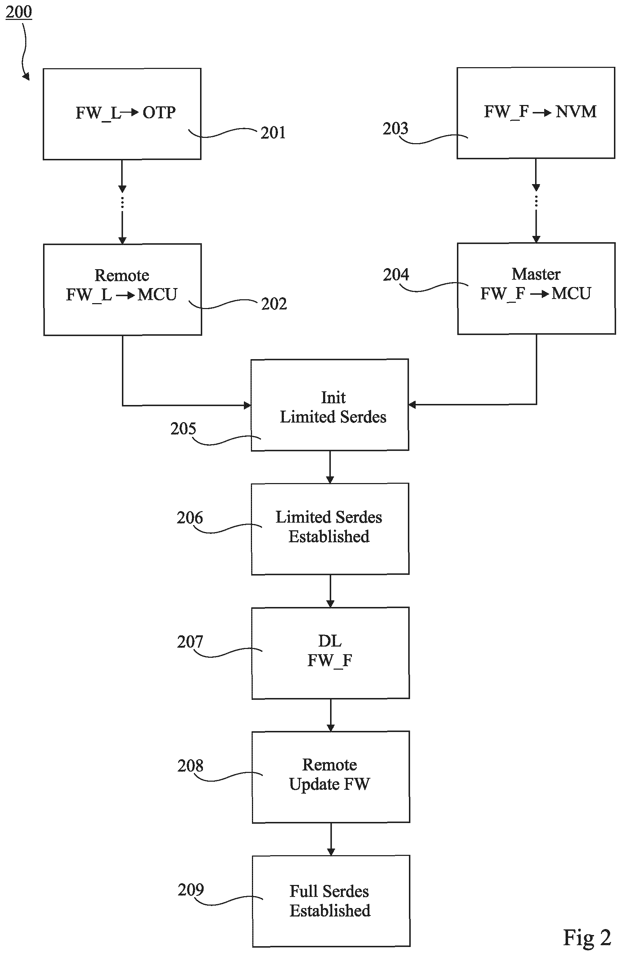

Selon un mode de réalisation, le logiciel 10221 permet d'initialiser une communication par sérialiseur/désérialiseur à plus fiable débit que le débit d'une telle communication mise en oeuvre par le logiciel 1031. L'initialisation d'une telle communication est décrite en détails en relation avec la figure 2.

Selon une variante de réalisation, le logiciel 10221 permet d'initialiser une communication par sérialiseur/désérialiseur à même débit que le débit d'une telle communication mise en oeuvre par le logiciel 1031, présentant des fonctionnalités différentes. Plus particulièrement, une communication initialisée par le logiciel 10221 peut présenter moins de fonctionnalités qu'une communication initialisée par le logiciel 1031. Selon un exemple, le logiciel 10221 peut ne pas mettre en oeuvre des fonctionnalités liées à l'adaptation à l'environnement dans lequel se trouve le système 100, comme par exemple une adaptation à la température ambiante.

Selon encore une variante de réalisation, le logiciel 10221 permet d'initialiser une communication par sérialiseur/désérialiseur à plus faible débit et présentant des fonctionnalités différentes qu'une communication mise en oeuvre par le logiciel 1031.

Un avantage de ce mode de réalisation est qu'en rendant accessible le logiciel 10221 directement au dispositifs 102, ils peuvent initialiser une communication de manière autonome. En effet, on aurait pu penser installer un canal de communication uniquement dédié à la transmission du logiciel 1031 au dispositif 102, mais cela ajoute des canaux de communication au système et donc augmente son encombrement, peut aussi réduire sa fiabilité.

La figure 2 est un schéma-bloc illustrant la mise en oeuvre d'une procédé d'initialisation 200 d'une communication par sérialiseur/désérialiseur au sein du système électronique 100 décrit en relation avec la figure 1. Plus particulièrement, communication concernée ici est une communication entre le dispositif 101 et un des dispositifs 102.

A une étape initiale 201 (FW_L -> OTP), le logiciel 10221 est stocké dans la mémoire morte programmable 1022 du dispositif 102. Selon un exemple, cette étape est réalisée après la fabrication du dispositif 102, par exemple, pendant une phase de test. Cette étape présente l'avantage de permettre à un utilisateur du système 100 de stocker la version du logiciel 10221 qu'il souhaite de manière simple, plutôt de devoir le demander au fabriquant du système 100 de le faire.

A une étape 202 (Remote FW_L ->MCU), successive à l'étape 201, le dispositif 102 veut mettre en oeuvre une communication par sérialiseur/désérialiseur avec le dispositif 101. Le logiciel 10221 est téléchargé depuis la mémoire 1022 vers le module 1021, puis est installé pour initialiser la communication par sérialiseur/désérialiseur.

A une autre étape initiale 203 (FW_F -> NVM), le logiciel 1031 est stocké dans la mémoire non volatile 103 du système 100. Selon un exemple, cette étape peut être réalisée à n'importe quelle étape de la vie du système 100, et plus particulièrement à n'importe quelle étape de la vie de la mémoire non volatile 103.

A une étape 204 (Remote FW_F ->MCU), successive à l'étape 203, le dispositif 101 veut mettre en oeuvre une communication par sérialiseur/désérialiseur avec le dispositif 102. Le logiciel 1031 est téléchargé depuis la mémoire 103 vers le module 1011, puis est installé pour initialiser la communication par sérialiseur/désérialiseur.

A une étape 205 (Init Limited Serdes), successives aux étapes 202 et 204, une communication par sérialiseur/désérialiseur est initialisée. Pour cela, le dispositif 101 utilise le logiciel 1031 qui permet de mettre en oeuvre une communication complète, par exemple à haut débit, et le dispositif 102 utilise le logiciel 10221 qui permet de mettre en oeuvre une communication limitée, par exemple à bas débit et/ou présentant moins de fonctionnalités. Seule une communication limitée peut donc initialisée entre les dispositifs 101 et 102, et une telle communication est initialisée.

A une étape 206 (Limited SerDes Established), successive à l'étape 205, une communication par sérialiseur/désérialiseur limitée a été initialisée et est prête à fonctionner. Selon un exemple, la communication peut transmettre et recevoir des données à un premier débit de données, par exemple un bas débit. Ce premier débit de données est, par exemple, de l'ordre de 3 Gbits/s.

A une étape 207 (DL FW_F), successive à l'étape 206, le dispositif 102 est alors adapté à recevoir le logiciel 1031 pour mettre en oeuvre complètement la communication par sérialiseur/désérialiseur. Pour cela, le dispositif 101 envoie, par la communication limitée initialisée, le logiciel 1031 au dispositif 102.

A une étape 208 (Remote Update FW), successive à l'étape 207, Le logiciel 1031 est reçu par le dispositif 102 qui le stocke dans la mémoire 10211 de son module 1021. Selon un exemple, le logiciel 1031 est utilisé pour mettre à jour le logiciel 10221, par exemple, sans interrompre la communication.

A une étape 209 (Full SerDes Established), successive à l'étape 208, le dispositif 102 utilise donc le logiciel 1031 pour mettre en oeuvre une communication par sérialiseur/désérialiseur complète. Selon un exemple, la communication peut transmettre et recevoir des données à un deuxième débit de données, par exemple un haut débit. Selon un exemple, le deuxième débit est supérieur au premier débit. Selon un exemple, le deuxième débit est de l'ordre de 112 Gbits/s.

Selon un mode de réalisation, le procédé d'initialisation 200 peut être inclus dans un procédé de communication par sérialiseur/désérialiseur.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Dispositif électronique (102) adapté à mettre en oeuvre une communication par sérialiseur/désérialiseur comprenant une première mémoire (1022) adaptée à stocker un premier logiciel (10221) adapté à initialiser ladite communication, ledit premier logiciel (10221) étant différent d'un deuxième logiciel (1031) adapté à mettre en oeuvre ladite communication.

2. Procédé d'initialisation (200) d'une communication par sérialiseur/désérialiseur par un dispositif électronique (102) comprenant une première mémoire (1022) adaptée à stocker un premier logiciel (10221) adapté à initialiser ladite communication, ledit premier logiciel (10221) étant différent d'un deuxième logiciel (1031) adapté à mettre en oeuvre ladite communication.

3. Dispositif selon la revendication 1, ou procédé selon la revendication 2, dans lequel ladite première mémoire (1022) est une mémoire morte programmable.

4. Dispositif selon la revendication 1 ou 3, ou procédé selon la revendication 2 ou 3, dans lequel le premier logiciel (10221) est une version abrégée dudit deuxième logiciel (1031) .

5. Dispositif l'une quelconque des revendications 1, 3 ou 4, ou procédé selon l'une quelconque des revendications 2 à 4, dans lequel, une fois que le premier logiciel (10221) a été utilisé, ledit dispositif (102) est adapté à recevoir ledit deuxième logiciel (1031).

6. Dispositif ou procédé selon la revendication 5, dans lequel ledit deuxième logiciel (1031) est envoyé par un premier circuit de commande (101) externe audit dispositif (102).

7. Dispositif ou procédé selon la revendication 5 ou 6, dans lequel ledit deuxième logiciel (1031) est stocké dans une deuxième mémoire (10211) dudit dispositif (102).

8. Dispositif ou procédé selon la revendication 7, dans lequel la deuxième mémoire (10211) est une mémoire vive statique d'un module sérialiseur/désérialiseur (1021) dudit dispositif (102).

9. Dispositif selon l'une quelconque des revendications 1, 3 à 8, ou procédé selon l'une quelconque des revendications 2 à 8, dans lequel ledit premier logiciel (10221) est adapté à initialiser ladite communication ayant un premier débit de donnée inférieur à un deuxième débit de données de ladite communication quand elle est mise en oeuvre par ledit deuxième logiciel (1031).

10. Dispositif selon l'une quelconque des revendications 1, 3 à 9, ou procédé selon l'une quelconque des revendications 2 à 9, dans lequel ledit premier logiciel (10221) est adapté à initialiser ladite communication ayant premières fonctionnalités différentes de deuxièmes fonctionnalités de ladite communication quand elle est mise en oeuvre par ledit deuxième logiciel (1031).

11. Dispositif selon l'une quelconque des revendications 1, 3 à 10, ou procédé selon l'une quelconque des revendications 2 à 10, dans lequel lesdits premier et deuxième logiciels sont des microcodes adaptés à envoyer directement des commandes à un ou plusieurs circuits et composants électroniques chargés de mettre en oeuvre une communication par sérialiseur/désérialiseur.

12. Dispositif selon l'une quelconque des revendications 1, 3 à 11, ou procédé selon l'une quelconque des revendications 2 à 11, dans lequel l'initialisation de ladite communication correspond au déclenchement d'un ou plusieurs circuits et composants électroniques chargés de mettre en oeuvre une communication par sérialiseur/désérialiseur.

13. Procédé de communication d'une communication par sérialiseur/désérialiseur comprenant le procédé selon l'une quelconque des revendications 2 à 12.

14. Système électronique (100) comprenant au moins un dispositif (101, 102) selon l'une quelconque des revendications 1, 3 à 12.
